## Europäisches Patentamt
## European Patent Office
## Office européen des brevets

(19)

(11) Publication number: **0 147 000**

**A1**

(12) **EUROPEAN PATENT APPLICATION**

(21) Application number: **84304554.3**

(22) Date of filing: **04.07.84**

(51) Int. Cl.⁴: **H 05 K 3/34**

(30) Priority: **15.12.83 US 561746**

(43) Date of publication of application:
**03.07.85 Bulletin 85/27**

(84) Designated Contracting States:
**AT BE CH DE FR GB IT LI NL SE**

(71) Applicant: **HOLLIS AUTOMATION INC.**
**Charron Avenue**
**Nashua New Hampshire 03063(US)**

(72) Inventor: **Boynton, Kenneth G.**
**Old County Road**
**Wilton New Hampshire 03086(US)**

(74) Representative: **Sommerville, John Henry et al,**
**SOMMERVILLE & RUSHTON 11 Holywell Hill**
**St. Albans Hertfordshire, AL1 1EZ(GB)**

(54) **Mass wave soldering system I.**

(57) Mechanical contact of a soldered component takes place immediately following deposition of molten solder onto the board. The mechanical contact relocates solder on and/or removes excess solder from the bottom of the board, and any interconnections, component leads and/or component bodies carried thereon before the solder solidifies as shorts, icicles or bridges.

FIG. 1

EP 0 147 000 A1

The present invention relates to systems for soldering electrical and electronic components onto substrate circuit boards, and more specifically to an improved apparatus and method for mass soldering electrical and electronic components by their leads, to printed circuit boards or the like.

Various soldering systems are well known in the art for mass soldering electrical and electronic components, by their leads, onto printed circuit boards. One technique for mass soldering components to circuit boards is that of dip soldering. With this technique, the entire side of a circuit board containing the printing wiring, with the leads from the components projecting through apertures in the board, is engaged for a certain period of time with the surface of a bath of molten solder, and then removed. Another technique for mass soldering components onto circuit boards is that of wave soldering. A typical prior art wave soldering system generally comprises a container adapted to hold a supply of molten solder and a sump partially submerged in the molten solder. The sump has an intake orifice below the surface of molten solder, and an elongate horizontal nozzle or slot above the surface of the solder. A positive displacement pump is submerged in the body of solder and is adapted to force molten solder into the sump intake orifice, where the molten solder then flows upward in the sump and out the horizontal nozzle to thereby produce a smoothly rounded standing wave of molten solder above the nozzle. Other techniques for mass soldering electrical and electronic components onto the printed circuit boards are well known in the art and include cascade soldering, jet soldering and drag soldering. So-called "leadless" components such as flat packs can also be mass soldered to circuit boards by fixing the components to the bottom of a board, e.g. as by fixturing or with an adhesive, and then engaging the bottom of the board and the components with molten solder. While known mass soldering systems have provided substantial manufacturing economy to the electronics industry and thus achieved substantial commercial use, the deposition of excess solder on the board circuits, connections and leads has been a continual problem. Deposition of excess solder may result in formation of shorts, icicles and/or bridges, and will increase solder consumption and finished board weight. Moreover, current trends in the electronics industry to relatively high density electronic assemblies has increased the problem of solder shorts, icicling and bridging.

The prior art has devised various techniques to solve the problems of solder shorts, icicling and bridging. For example, for wave soldering, one technique which has become virtually universally adopted by the industry is to incline the travel path of the circuit boards through the solder wave, i.e. from the horizontal, to increase the exit angle between the board being soldered and the solder wave. The art has also devised various wave geometries for further increasing the exit angle and/or changing the point where a circuit board exits the wave. While increasing the exit angle of the board from the wave has been found to reduce substantially the incidence of solder shorts, bridges and/or icicling, this has not entirely eliminated solder shorts, bridges and icicling, particularly in cases where relatively high density electronic assemblies and/or relatively long lead components are being soldered. Moreover, inclining the conveyer, i.e. so as to increase the exit angle increases the height of the soldering system and also complicates the transport system between the assembly station and the cleaning station which normally employ horizontal conveyers. Modifying the sump and nozzle to increase the exit angle and/or changing the point where the circuit board exits the wave complicates wave geometries and control.

Another system for reducing the incidence of solder shorts, icicling and bridging, which has achieved substantial commercial acceptance, is to intimately mix soldering oil in the solder wave in accordance with the teachings of Walker et al U.S. Patent 3058441. While such systems have been found to reduce substantially the incidence of solder shorts, bridging and/or icicling, such systems have not entirely eliminated solder shorts, bridges and icicling, particularly in cases where relatively high density electronic assemblies and/or relatively long lead components are being soldered to circuit boards.

A more recent development in mass soldering systems and which also has achieved substantial commercial acceptance, is described in Canadian Patent No. 1091102, Canadian Patent No. 109641, and the U.S. Patents Nos. 4,401,253 and 4,410,126 of Harold T. O'Rourke, for Mass Soldering System, all assigned to the assignee of the present application. The aforesaid Canadian Patents and U.S. Patents disclose mass soldering systems wherein after the board has been contacted with the molten solder, excess solder deposited by the soldering process is removed by impinging a stream of heated gas onto the freshly deposited solder before it solidifies on the board. In practice, a stream of heated air is directed onto the underside of the board from one or more fluid jets, fluid lenses, slots, nozzles or the like located immeditely downstream of the mass soldering station and directed at a relatively acute angle (30 to 60°) to

the underside surface of the board. While such systems have been found to eliminate substantially the incidence of solder shorts, bridging and/or icicling in mass soldering operations, as will be appreciated such systems impose increased energy demands, i.e. for generating the necessary heated gas stream.

Yet another recent development which purportedly reduces solder shorts, bridging and/or icicling in a mass soldering operation is described in U.K. Patent Application GB 2112688A, Published 27 July 1983. As described in the aforesaid U.K. published Patent Application a static pool of hot oil having a specific gravity lower than solder is floated in a depression in the surface of a standing wave of solder. Circuit boards to be soldered are passed through the crest of the molten solder wave and then, while the solder adhering to the component leads and conductors still is molten, into contact with the static pool of hot oil.

It is thus a primary object of the present invention to provide a mass soldering system, i.e. apparatus and process, which overcomes the aforesaid problems of the prior art.

Another object of the present invention is to provide an improved apparatus and process for mass soldering in which the problems of solder shorts, icicling and/or bridging are substantially reduced.

A more specific object is to provide an apparatus and process for mass soldering relatively high density circuit board assemblies.

The instant invention overcomes the foregoing and other problems by providing a method and apparatus for relocating or removing excess solder from mass soldered boards before the solder solidifies as shorts, icicles or bridges. The method comprises the step of mechanically contacting solder deposited on the underside of a soldered board substantially immediately following mass deposition of the molten solder onto the board. Contact may be a brushing action on the underside of the board which relocates excess solder on, and/or removes excess solder therefrom and any interconnection, component leads and/or component bodies carried thereon before the solder solidifies as shorts, icicles or bridges. The brushing action may take place closely adjacent the peel back point of the solder wave from the board or subsequently in combination with the supply of soldering oil to the bottom of the board. Further, the brushing action may be used, in combination with a supply of soldering oil, to brush only the depending ends of component leads soldered to the board. The brush(es) may comprise a non-wetting metal (e.g. titanium).

In the following description the term "solder removal" is used to denote actual displacement of solder from a circuit board, and any interconnections, component leads and/or component bodies thereon, as well as relocation of solder on a circuit board, and any interconnections, component leads and/or component bodies thereon.

According to the present invention there is provided a method of mass joining with solder printed circuit boards and leads of components mounted thereon, said method comprising the steps of:

depositing a quantity of molten solder onto the underside of said board and said leads, and, substantially immediately following said depositing, mechanically contacting solder on the underside of said board and leads thereby to relocate or remove a portion of the molten solder deposited on said board and leads before said molten solder solidifies thereon.

The present invention will now be described, by way of example, with reference to the accompanying drawings, in which:

Fig. 1 is a diagrammatic side elevation of a mass soldering system according to the present invention;

Fig 2A is a side elevation, partly in section, of the soldering apparatus portion of the soldering system of Fig. 1, illustrating a first embodiment of the present invention;

Fig. 2B is an enlarged illustration of a portion of Fig. 2A;

Fig 3 is a plan view of the soldering apparatus portion of Fig 2;

Fig. 4 is a diagrammatic side elevation, partly in section, of the soldering apparatus portion of the soldering system of Fig. 1 and a solder relocation and/or removal station, illustrating a second embodiment of the present invention;

Fig. 5 is a plan view of the soldering apparatus portion of Fig; 4;

Fig. 6 is a side elevation, partly in section, of the soldering apparatus portion of the soldering system of Fig. 4 modified to illustrate a variation of the second embodiment of the present invention; and

Fig. 7 is a diagrammatic side elevation of a second soldering apparatus including the second embodiment of the present invention, taken along the travel path of a circuit board;

In the following detailed description of the present invention, the term "component" refers to leadless components as well as components having conventional metallic conductors or leads. The term "component lead" refers to that part of metallic conductor of an electrical or electronic component that is joined to the printed circuit board pattern, i.e. the component leads, terminals, lugs, pins, etc. The term "land" as used herein refers to that part of the metallic pattern on the printed circuit board to which a component or component lead is joined by solder. The term "mass soldering" as used herein is intended to refer to any of the several soldering techniques known in the art in which liquid solder is applied to a circuit board from a reservoir of liquid solder, including, by way of example, but not limitation: wave soldering, touch or dip soldering, pot soldering, jet soldering, cascade soldering and drag soldering.

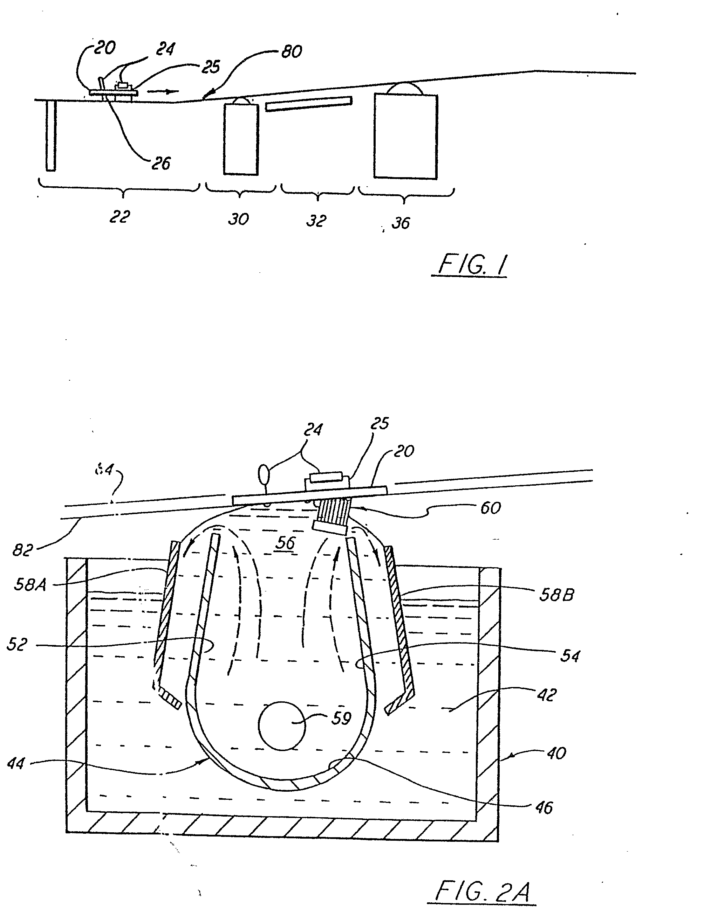

Referring first to Fig. 1, a printed circuit board 20 is loaded at an insertion station 22, with a plurality of electrical or electronic components 24 at predetermined positions on the board. The board comprises an insulated wiring board having one or more printed metallic conductors on the board underside, and a plurality of apertures 25 which extend through the board. Components 24 are loaded onto the top side of the board with their leads 25 protruding downward through the board apertures 25 in juxtaposition to the circuit lands to which they are to be joined. The components may be inserted in the board by any method known in the art which may include manual assembly, semi-automatic, or automatic assembly which may comprise single-station or multiple-station pantograph or numerically controlled machines, all of which are well known in the art and need not be described further.

The next step involves treating the surfaces to be soldered with a so-called flux at a fluxing station 30. The flux may be any flux well known in the art and may include, for example, a water-white rosin flux, an activated rosin flux or a water soluble flux. The flux may be applied in fluxing station 30 by any manner well known in the art, for example, by spraying, foaming, brushing, or from a flux wave.

The board is then passed from fluxing station 30 to a preheating station 32 where the board is preheated to mobilize the flux and also drive off the bulk of the flux solvent to form an active flux layer on the board and leads. Preheating station 32 may comprise infrared or convection heaters or a combination of infrared and convection heaters as are well known in the art. Preferably, but not necessarily, preheating station 32 is extended as compared with conventional preheating stations, and/or preheating station 32 may be operated at higher than normal temperatures so that the board 20 is heated to higher than normal top side temperatures. Thus board 20 will be preheated to a minimum top side temperature of about 66$^{\circ}$C; preferably however, the board will be preheated to a top side temperature in the range of about 100$^{\circ}$C - 125$^{\circ}$C or higher. The purpose of preheating the board to higher than normal top side temperatures is to increase the time the solder on the board remains molten after the board emerges from the solder wave. The reason for this will become clear from the description following.

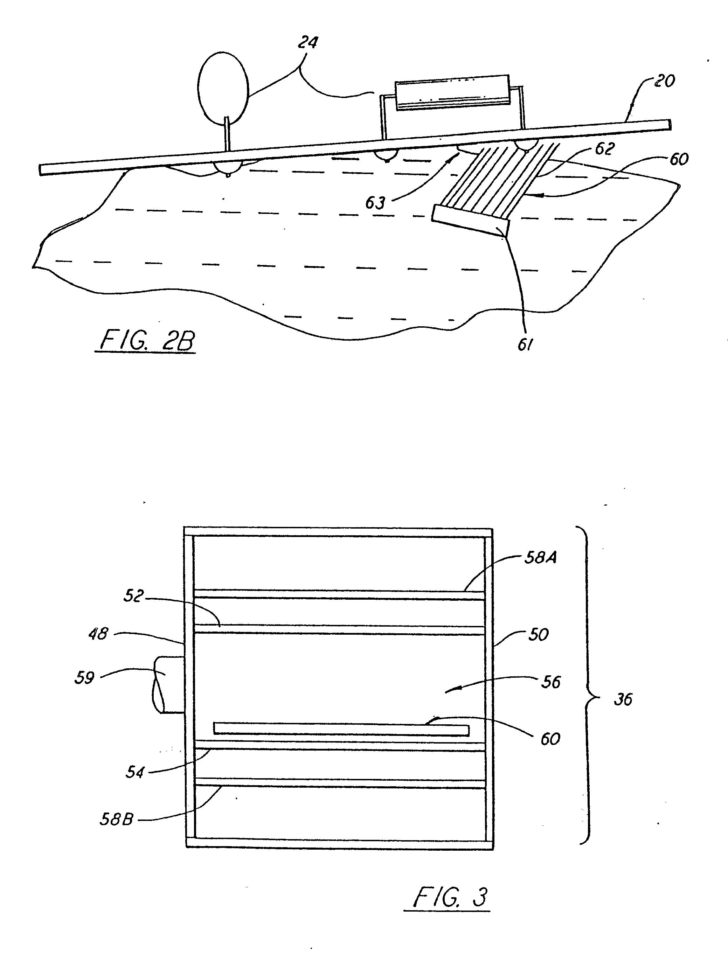

The fluxed preheated board is then passed to a mass wave soldering station 36. Referring also to Figs. 2 and 3 the wave soldering station includes a container of conventional design, indicated generally at 40, for holding a supply of molten solder 42. Conventional heating means (not shown) may be secured to the bottom and/or side walls of container 40 or immersed in the solder to heat and maintain the supply of solder 42 in molten condition.

A sump and nozzle assembly indicated generally at 44 is disposed interiorly of container 40. The sump and nozzle assembly 44 is of conventional design and typically comprises a rounded bottom wall 46, a pair of substantially vertically opposed end walls 48 and 50, and a pair of inclined side walls 52 and 54. The upper ends of end walls 40 and 50 and side walls 52 and 54 are spaced from one another to form a narrow elongate rectangular nozzle or slot 56 which extends above the molten solder level in container 40 for a suitable distance, e.g one inch above the molten solder level.

Preferably, the sump also includes a pair of adjustable sluice plates 58A, 58B spaced from the sump side walls 52 and 54 for controlling solder overflow from the nozzle 56, e.g. in accordance with the teachings of U.S. Patent No. 3398873 to Kenneth G. Boynton. Completing the soldering station is a variable speed pump (not shown) which communicates through an intake orifice 59 in the lower end of sump and nozzle assembly 44 for pumping solder into the sump where it then rises and overflows the nozzle 56 as a standing solder wave.

An important feature and critical requirement of the present invention is the ability to relocate excess solder on, and/or remove excess solder from the bottom of the circuit board, and from any interconnections, component leads and/or component bodies carried thereon before the solder can solidify as shorts, icicles and/or bridges. This is accomplished by treating the soldered circuit board and depending component leads at an excess solder relocation and/or removal station. The excess solder relocation and/or removal station may be incorporated in the mass soldering station 36 or as a separate station 100 immediately following soldering station 36 in-line therewith and is designed to mechanically relocate and/or remove excess solder from the board underside before the solder solidifies as shorts, icicles and/or bridges.

With reference to Figs. 2A, 2B and 3, which illustrate a first embodiment of the present invention in which the solder relocation and/or removal takes place in the mass wave soldering station 36. In this embodiment an elongate wire brush 60 having an elongate base 61, supported in parallel relationship adjacent the elongate nozzle or slot 56, and having metal bristles 62 supported by base 61 is located in the downstream side of the solder wave. As seen particularly in Fig. 2B brush 60 is positioned so as to extend into close proximity with the underside of a board 20, as the board is conveyed through the mass wave soldering station 36, adjacent and downstream, in the conveying direction, of the peel-back line 63 from the underside of board 20. As the board 20 is conveyed past brush 60 the excess solder on the underside of board 20 is relocated and/or removed, by the sweeping action of bristles 62, before this excess solder can solidify as shorts, icicles and/or bridges. Bristles 62 should be spaced sufficiently from the underside of the board 20 so as not to disturb fillet formation, but only remove or relocate excess solder. One skilled in the art will be able to determine experimentally the preferred operating parameters for achieving icicle-, bridge-, and short-free mass soldering for the particular board being soldered. It will be appreciated that said spacing may vary in dependence upon, for example, the size and shape of the board 20 and solder wave, component diameter and length, bristle spacing and dimensions, board, component lead and solder temperature, distance of the bristles downstream of the wave peel-back line, materials involved and conveying speed. The appropriate spacing will be readily ascertained in any particular circumstance. It will also be appreciated that in appropriate conditions the bristles may lightly contact the component leads and/or lands of the board 20.

The bristles are constructed to have an exterior surface which will not become wetted by solder.  To achieve this the bristles may be constructed entirely of a non-netting metal, (e.g, titanium) or may have a metallic wire core coated by a material, such as polytetrafluoroethylene, which will withstand the temperature of the solder wave while possessing the necessary non-wetting characteristics.

While bristles 62 are illustrated in the first and preferred embodiment as angled from the base 61 downstream to their ends adjacent the board 20, other embodiments in which the bristles are normal to the plane of the board or have other angular relationships thereto are contemplated.

Oil intermix with the solder in the solder wave may be provided in order to eliminate excessive dross formation at the brush.

Completing the soldering system is a circuit board conveyor 80 of conventional construction.  The latter comprises a pair of spaced conveyor rails 82 and 84 and suitable drive means (not shown) for carrying a circuit board from the insertion station 22 through the fluxing station 30, wave soldering station 36 and excess solder removal station.

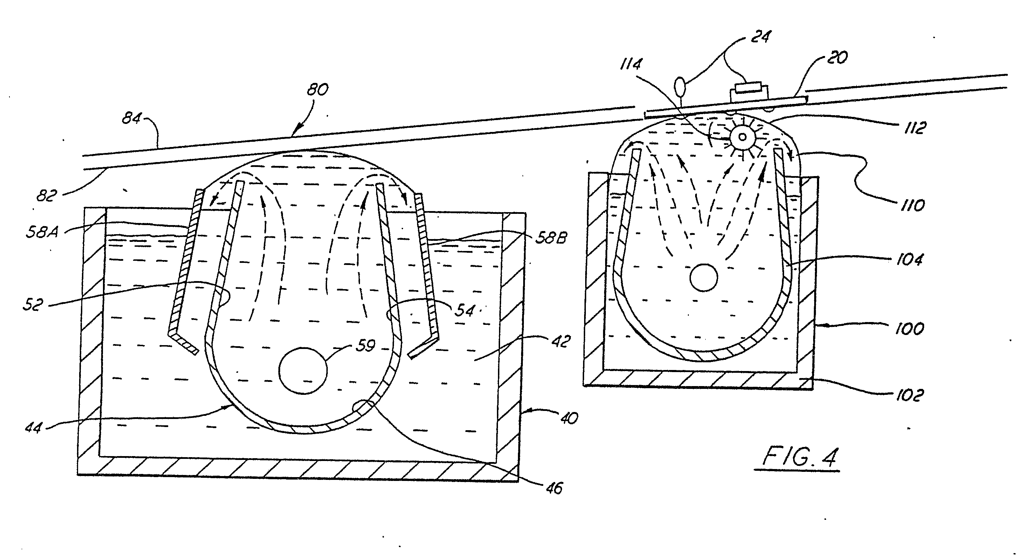

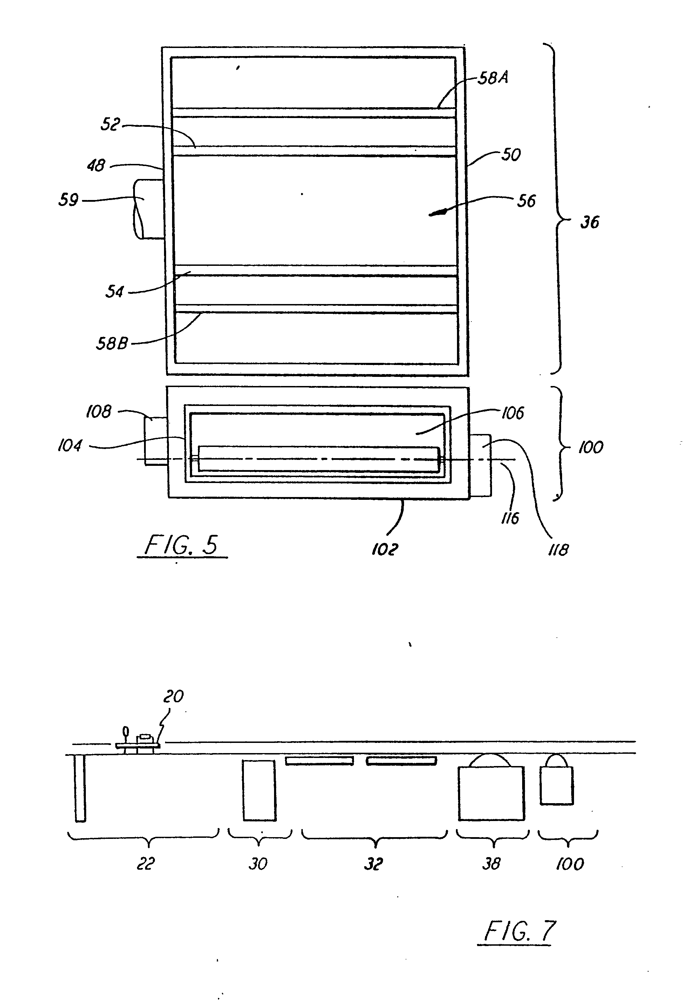

With reference now to Figs. 4 and 5, which illustrate a second embodiment of the present invention in which a solder relocation and/or removal station 100 is provided closely adjacent the wave soldering station 40 downstream thereof relative to the direction of conveyance of a board 20 through the mass soldering system.  The solder relocation and/or removal station 100 which includes a container 102 for holding a supply of heated oil (i.e., soldering oil) e.g., Peblum oil as manufactured by Shell Oil Company.  Peblum oil is approximately 85% of an unfiltered HVI (high viscosity index) bright stock having a viscosity of about 200 Saybolt Universal Seconds at 99°C., 0.5% phenyl-alpha-naphthylamine, and the remainder a mixture of fatty acid material, about one-half of which is hydrogenated marine oil distillate and one-half unsaturated fatty acid. Additional information regarding compositions of this type may be found in U.S. Patent No. 2,537,882 of George W. Waters. The oil must be a relatively inert oil, such as Peblum oil, and liquid from below room temperature, 20°C to temperatures in excess of solder bath, 250°C. Conventional heating means (not shown) may be secured to the bottom and/or side walls of container 102 or immersed in the solder to heat and maintain the supply of oil at a temperature approximating that of the solder in the solder wave (i.e., about 280°C) and in any event, higher than the liquidus temperature of the solder.

An oil sump and nozzle assembly 104, disposed interiorly of container 102, is of design generally similar to that of solder sump and nozzle 44 to define a rectangular nozzle or slot 106 which extends above the oil level in container 102 for a suitable distance, e.g. one inch. A variable speed pump 108 is attached to container 102 to pump oil upwardly through the nozzle or slot 106 to form a stationary oil wave 110 of a height sufficient to engage the underside of a board 20 as it is conveyed on conveyor 80. Within the oil wave 110 downstream of the crest of the wave is an elongate cylindrical brush 112 mounted for rotation in the direction of arrow 114 about axis 116 by a motor 118. The bristles of brush 112 are spaced from the underside of board 20 in similar manner to those of brush 60, and are constructed of a fine wire (or other material or combination of materials able to operate satisfactorily at the temperatures to which they are exposed) and in conjunction with the oil wave 110 perform the same function as described above with respect to brush 60.

One skilled in the art will be able to determine experimentally the preferred operating parameters for achieving icicle-, bridge- and short-free mass soldering for the particular board being soldered in the embodiment of Figs. 4 and 5.

It will be appreciated that a fixed elongate brush similar to that described with reference to Figs. 2A, 2B and 3 (although materials may differ) could be substituted for the brush 112 and similarly that a rotatable cylindrical brush might be utilized in the first embodiment of the invention.

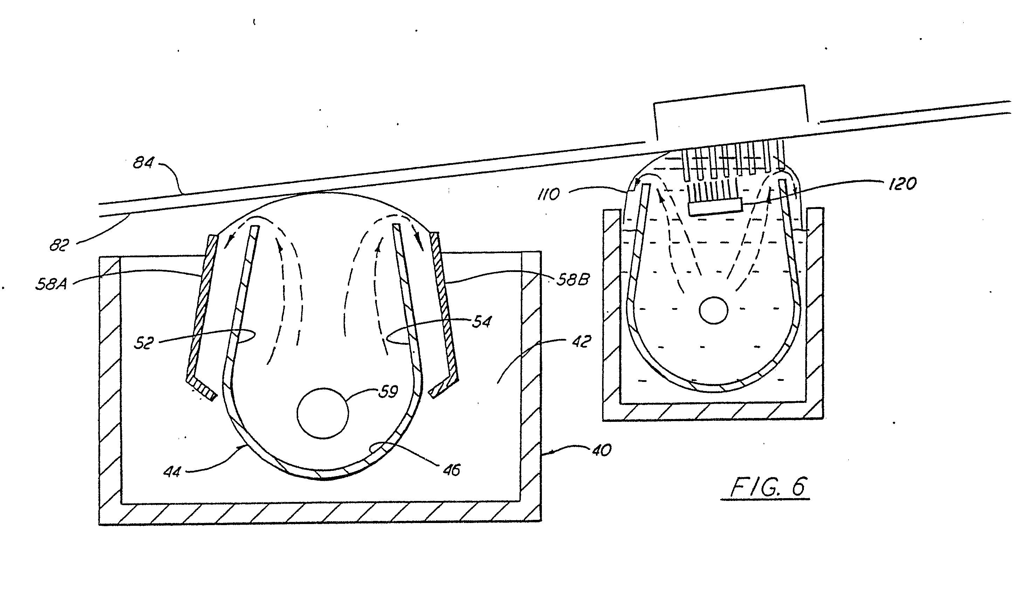

With reference to Fig. 6 an apparatus similar to that of Figs. 4 and 5 is illustrated in which the elongate cylindrical brush 112 and its drive motor 118 are replaced by an elongate brush 120 submerged in the oil wave 110 and positioned to engage the depending ends only of the leads of a DIP (Dual Inline Package) component or components with similar depending lead arrangements, the leads of which have been tinned in the mass wave soldering station. In this apparatus the excess solder is removed from the tips of the component leads while the oil wave ensures that any excess solder present on the faces of the leads will migrate under the influence of gravity to the tips thereof for removal by the brush 120.

One skilled in the art will be able to determine experimentally the preferred operating parameters for achieving icicle-, bridge- and short-free mass soldering for the particular board being soldered in the arrangement of Fig. 6.

As with the other embodiments and arrangements described herein the brush 120 may in fact be spaced in close proximity to the lead ends without having actual physical contact with anything but the excess solder to be removed.

Referring now to Fig. 7, which illustrates a second form of mass wave soldering system in accordance with the present invention shown in the second embodiment of the invention. The mass wave soldering system illustrated in Fig. 7 has many similarities to the mass wave soldering system shown in Fig. 1. Thus for example, the mass wave soldering system in accordance with the present invention also includes a loading station 22, a fluxing station 30, a preheating station 32 and a mass wave soldering station 36. However, in contrast to the system of Fig. 1 the board 22 is carried substantially horizontally through the crest of the solder wave. It will be appreciated that the other embodiments of the present invention could also be used in conjunction with horizontal conveyance of boards through the crest of the solder wave.

Also preferred, but not essentially required, is the extension of the preheating station 32, as compared with conventional preheating stations, and/or the operation of the preheating station 32 at higher than normal temperatures, so that the board 22 will be heated to a top side temperature 14 to 28$^{o}$C or more higher than normal. Thus, for example, board 22 may be preheated in accordance with the present invention to a minimum top side temperature of about 66$^{o}$C, preferably a top side temperature in the range of about 79$^{o}$C to 121$^{o}$C. The purpose of preheating the board to higher than normal top side temperature is to increase the time the solder on the board remains molten after the board emerges from the solder wave.

As described in connection with the embodiment of Fig. 4 and 5 excess solder is relocated and/or removed

from the bottom of board 20 substantially immediately after the board emerges from the solder wave at solder relocation and/or removal station 100 as described with reference to those Figures. The higher temperatures ensure relocation or removal of excess solder notwithstanding the reduced peel-back angle resulting from operating in the horizontal mode.

Beyond this the operation and arrangement of the system of Fig. 7 is essentially the same as that described above for the system shown in Fig. 1, 4 and 5.

Various changes may be made in the foregoing invention without departing from the inventive features described herein. For example, one or more banks of heaters, similar in construction to the preheaters may be incorporated into the excess solder relocation and/or removal station to extend the time the solder remains molten on the board.

While the solder relocation and/or removal station in accordance with the present invention has been illustrated in conjunction with a mass wave soldering system, one skilled in the art will recognize that similar advantages may be achieved by employing a solder removal station in conjunction with other types of mass soldering systems such as dip, cascade, jet and drag soldering systems. Also, as noted supra, the present invention advantageously may be employed for tinning the leads of multi-lead components such as DIP's, SMD's or the like. Still other changes will be obvious to one skilled in the art. Accordingly, it is intended that all matter contained in the above description or shown in the accompanying drawings shall be interpreted in an illustrative and not in a limiting sense.

CLAIMS

1. A method of mass joining with solder printed circuit boards and leads of components mounted thereon or of pretinning the leads of a multilead component, said method being characterized by the steps of:

depositing a quantity of molten solder onto the underside of said board and said leads, and, substantially immediately following said depositing, mechanically contacting solder on the underside of said board and/or leads thereby to relocate or remove a portion of the molten solder deposited on said board and/or leads before said molten solder solidifies thereon.

2. A method according to claim 1, characterized in that said solder is deposited onto said board and leads by passing the underside of said board and/or leads at least in part into contact with and through the crest of a wave of molten solder, and wherein said mechanically contacting said solder on the underside of said board and leads is caused substantially immediately following contact of said board and leads with said solder wave.

3. A method according to claim 2, characterized in that said board is or leads are transported substantially horizontally through said wave of molten solder and said mechanical contacting takes place immediately following peel-back of said wave from the underside of the board or leads.

4. A method according to claim 3, characterized in that said mechanical contacting is by means of a brush lying at least partially within said wave, said brush having bristles which may project from said wave for said mechanical contacting.

5. A method according to claim 4, characterized in that said brush is a rotatable cylindrical brush defining a longitudinal axis parallel to said crest of said wave, and said brush is rotated relative to said board or said leads.

6. A method according to claim 4 or 5, characterized in that, in the case of a board, said brush is spaced from and in close proximity with said underside of said board.

7. A method according to claim 2, characterized by the steps of bringing of the underside of said board and/or leads into contact with a wave of oil immediately following immersion of said board and said leads in contact with said solder wave, and wherein said mechanical contacting takes place within or adjacent said oil wave.

8. A method according to claim 7, characterized in that said mechanical contacting is by means of a brush disposed at least partially within said oil wave, brush in one form being a rotatable cylindrical brush defining an axis about which said brush rotates during said mechanical contacting.

9. A method according to claim 8, characterized in that said brush is immersed in said oil wave and located to contact only dependent ends of components leads extending downwardly from the underside of said board or said leads.

10. Apparatus for mass joining with solder leads of components and a circuit board to which they are assembled or for pretinning leads of a multilead component, comprising in combination:

a mass soldering station (36) adapted to hold a supply of molten solder; and

means (80) for transporting said circuit board and/or leads through said soldering station whereby a quantity of molten solder may be deposited onto the underside of said board and/or said leads; characterized by

an excess solder relocation or removal means (60 or 100) adjacent said mass soldering station arranged to mechanically contact said excess solder to remove or relocate a portion of said deposited molten solder from said board and/or leads before said molten solder solidifies thereon.

11. Apparatus according to claim 10, characterized in that said soldering station is a mass wave soldering station adapted to generate a standing wave of molten solder, and said transporting means are arranged to transport said circuit board and/or leads into and through contact with the crest of said standing wave.

12. Apparatus according to claim 11 characterized in that said transporting means is arranged to transport said circuit board in a substantially horizontal travel path through said soldering station and/or said excess solder relocation or removal means (60 or 100) is positioned to mechanically contact said excess solder immediately following peel-back of said wave from the underside of the board.

13. Apparatus according to claim 12, characterized in that said mechanical contact is by means of a brush (60, 114 or 120) lying at least partially within said wave, when generated in said soldering station, said brush having bristles which may be arranged to project from said wave to provide said mechanical contact.

14. Apparatus according to claim 13, characterized in that said brush is a rotatable cylindrical brush (114) defining a longitudinal axis, parallel to the crest of said wave when generated in said soldering station, and means (118) are provided to rotate said brush about its longitudinal axis relative to said board and/or said leads.

15. Apparatus according to claim 13, characterized in that, in the case of a board, said brush is positioned to be spaced from and in close proximity with said underside of said board during excess solder relocation or removal.

16. Apparatus according to claim 12, characterized by means (106, 108) for generating a wave of oil to contact the underside of said board and/or said leads immediately downstream of the location of contact of the underside of said board and/or leads in said solder wave, simultaneously and in cooperation with said mechanical contact with said excess solder.

17. Apparatus according to claim 16, characterized in that said mechanical contact is by means of a brush 114 or 120) disposed to be at least partially within said oil wave, when generated, said brush in one form being a rotatable cylindrical brush (114) defining a longitudinal axis with means (118) being provided to rotate said brush about its longitudinal axis during said mechanical contact.

18. Apparatus according to claim 17, characterized in that said brush (120) is positioned to be immersed in said oil wave, when generated, and located to contact, during solder relocation or removal, only dependent ends of component leads.

19. Apparatus according to claim 13, characterized in that the brush has bristles having surfaces which are non-wetting in solder, said bristles in one form comprising metal, for example, titanium.

FIG. I

FIG. 2A

0147000

FIG. 2B

FIG. 3

_FIG. 4_

58A

52

48

59

50

56

36

54

58B

108

104

106

100

102

116

118

*FIG. 5*

20

22

30

32

38

100

*FIG. 7*

_FIG. 6_

0147000

. Application number

**European Patent Office**

## EUROPEAN SEARCH REPORT

| | DOCUMENTS CONSIDERED TO BE RELEVANT | | EP 84304554.3 | |
|---|---|---|---|---|
| Category | Citation of document with indication. where appropriate, of relevant passages | Relevant to claim | CLASSIFICATION OF THE APPLICATION (Int. Cl.4) | |
| A | <u>DE - B2 - 2 619 342</u> (SCHLEUNIGER)<br>* Claims 1-18; fig. 1-6 *<br>-- | 1-3,7,<br>10-12,<br>16 | H 05 K 3/34 | |
| D,A | <u>US - A - 4 410 126</u> (O'ROURKE)<br>* Abstract; claims 1-19; fig. 1,2 *<br>-- | 1-3,7,<br>10-12,<br>16 | | |
| D,A | <u>US - A - 4 401 253</u> (O'ROURKE)<br>* Abstract; claims 1-27; fig. 1,2 *<br>-- | 1-3,7,<br>10-12,<br>16 | | |
| D,A | <u>GB - A - 2 112 688</u> (RCA)<br>* Abstract; claims 1-14; fig. 1 *<br>-- | 1-3,7,<br>10-12,<br>16 | | |
| D,A | <u>US - A - 3 058 441</u> (WALKER)<br>* Claims 1-4; fig. 3,4 *<br>-- | 1-3,7,<br>10-12,<br>16 | TECHNICAL FIELDS SEARCHED (Int. Cl.4)<br><br>H 05 K 3/00<br>B 23 K 1/00 | |
| A | <u>GB - A - 2 117 690</u> (ZEVATRON)<br>* Abstract; fig. 1-4 *<br>-- | 1-3,10-<br>12 | B 23 K 3/00 | |
| A | <u>US - A - 3 921 888</u> (ELLIOT)<br>* Abstract; fig. 1-4 *<br>-- | 1-3,10-<br>12 | | |
| A | <u>DE - A1 - 3 205 276</u> (ZEVATRON)<br>* Abstract; fig. 1 *<br>-- | 1-3,10-<br>12 | | |

The present search report has been drawn up for all claims

| Place of search | Date of completion of the search | Examiner |
|---|---|---|
| VIENNA | 19-03-1985 | VAKIL |

European Patent
Office

**EUROPEAN SEARCH REPORT**

0147000

Application number

| | DOCUMENTS CONSIDERED TO BE RELEVANT | | EP 84304554.3 |
|---|---|---|---|

| Category | Citation of document with indication, where appropriate, of relevant passages | Relevant to claim | CLASSIFICATION OF THE APPLICATION (Int. Cl.4) |
|---|---|---|---|
| D,A | <u>CA - A - 1 091 102</u> (COOPER) <br> * Claims 1-13; fig. 1-9 * <br> ---- | 1-3,10-12 | |
| | | | **TECHNICAL FIELDS SEARCHED (Int. Cl.4)** |
| | The present search report has been drawn up for all claims | | |

| Place of search | Date of completion of the search | Examiner |
|---|---|---|
| VIENNA | 19-03-1985 | VAKIL |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on. or after the filing date
D : document cited in the application
L : document cited for other reasons

& : member of the same patent family, corresponding document

EPO Form 1503 03 82